# EUROPEAN PATENT APPLICATION

(11) **EP 3 945 608 A1**
(43) Date of publication of application: **02.02.2022**
(21) Application number: 20315373.9
(22) Date of filing: 31.07.2020
(51) Int. Cl.: H01L 31/078, H01L 51/42

(54) **TWO TERMINAL PEROVSKITE/SILICON TANDEM SOLAR CELL AND ASSOCIATED MANUFACTURING METHOD**

(71) Applicant: TOTAL SE, 92400 Courbevoie (FR); Electricité de France, 75008 Paris (FR); L'AIR LIQUIDE Société Anonyme pour l'Etude et l'Exploitation des Procédés Georges Claude, 75007 Paris (FR); Centre National de la Recherche Scientifique, 75016 Paris (FR); Ecole Polytechnique, 91120 Palaiseau (FR); Institut Photovoltaique d'Ile de France, 91120 Palaiseau (FR)
(72) Inventor: Schulz, Philip, 94260 Fresnes (FR); Huang, Yong, Guilin, 541002 (CN)
(74) Representative: Croonenbroek, Thomas Jakob

(57) **Abstract**

The present invention refers to a two terminal tandem cell (1) comprising:
- a silicon bottom cell (2) comprising a silicon layer (5), a rear contact (3) configured to be linked to a first terminal and a front contact (7),
- a perovskite top cell (4) comprising a layer of perovskite (15) and a capping layer (17),
wherein the perovskite top cell comprises alternated back contacts made by a first carrier transport layer (9) arranged on the front contact (7) of the silicon bottom cell (2) to produce a recombination layer and a tunnel junction interface and a second carrier transport layer (13) configured to be linked to a second terminal and wherein an insulator layer (11) is arranged on one side between the silicon bottom cell (2) and the second carrier transport layer (13) and on the other side between the first carrier transport layer (9) and the second transport layer (13).

## Description

### Background of the invention

The present invention refers to photovoltaic energy production and in particular high efficiency photovoltaic cells, or solar cells, enabling the conversion of the solar energy into electricity.

With climate change, global warming and the fossil fuel depletion, many technologies have been developed over the past few years in order to use alternate resources and in particular renewable energy resources.

A solar cell comprises a P-N junction wherein light is absorbed to create electron-hole pairs and opposite electrodes to collect electrons on one side and holes on the other side.

In order to improve the efficiency of the photovoltaic cells, one way is to stack two photovoltaic cells having different bandgaps to form a tandem photovoltaic cell wherein each photovoltaic cell will convert a different part of the solar spectrum of the incoming light.

The tandem photovoltaic cells usually comprise a back photovoltaic cell based on silicon and having a bandgap around 1.1 eV.

The front photovoltaic cell needs to have a higher bandgap, preferably around 1.7 eV. Perovskite based solar cells enable to achieve such bandgap with a limited cost and are therefore promising candidates for highly efficient tandem solar cells.

However, perovskite absorber materials have also drawbacks, in particular their limited stability with respect to H₂O and O₂. Indeed, perovskite may be degraded by the presence of O₂ and H₂O in its environment so that perovskite needs to be protected from such degradation. One way to protect perovskite is to add encapsulation layers over the perovskite. The encapsulation layers refer notably to a layer of indium tin oxide (ITO) arranged on the top of the perovskite layer and providing a transparent carrier transport layer. However, to obtain a good lateral conductivity, the ITO layer requires a high temperature process, for example higher than 200°C leading to a degradation of the perovskite. Furthermore, the transparent conductive oxides (TCO) such as ITO arranged above the perovskite layer lead to parasitic absorption in the near infra-red spectrum and therefore limit the efficiency and tend to be expensive.

It is therefore necessary to find a solution enabling the production of a perovskite based tandem cell wherein the perovskite is protected by passivation layers without requiring high temperature process, notably process requiring a temperature higher than 110°C in order to avoid the perovskite degradation during the manufacturing process.

The present invention aims therefore at providing a solution to obtain a tandem photovoltaic cell based on silicon and perovskite sub-cells with good resistance against oxidation contaminants and high power conversion efficiency.

### Summary of the invention

The present invention refers to a two terminal tandem cell comprising:
- a silicon bottom cell comprising a silicon layer, a rear contact configured to be linked to a first terminal and a front contact,
- a perovskite top cell comprising a layer of perovskite and a capping layer,
wherein the perovskite top cell comprises alternated back contacts made by a first carrier transport layer arranged on the front contact of the silicon bottom cell to produce a recombination layer or tunnel junction interface and a second carrier transport layer configured to be linked to a second terminal and wherein an insulator layer is arranged on one side between the silicon bottom cell and the second carrier transport layer and on the other side between the first carrier transport layer and the second transport layer.

The first and the second carrier transport layers may have opposite doping type and the combination of the first carrier transport layer, the insulator layer and the second carrier transport layer may produce a P-I-N junction (or a series of P-I-N junctions). Besides, by opposite doping type it is herein meant that one layer has a N-type doping and the other layer has a P-type doping. The second carrier transport layer may be linked to the second terminal via lateral metallic contacts.

The two terminal tandem cell may present one or several of the following aspects taken alone or in combination.

According to another aspect of the present invention, the electrical conductivity, the thickness and the pitch of the second carrier transport layer are configured to ensure lateral carrier transport toward the second terminal.

According to a further aspect of the present invention, the second carrier transport layer comprises at least one sub-layer made of metal or transparent conducting oxide to enhance lateral carrier transport toward the second terminal.

According to another aspect of the present invention, the first carrier transport layer and the second carrier transport layer have opposite doping type. One is n-doped whereas the other one is p-doped

According to a further aspect of the present invention, the thickness of the first carrier transport layer, the second carrier transport layer and the insulator layer is comprised between 2nm and 1µm, preferably between 10nm and 100nm.

According to another aspect of the present invention, the thickness of the perovskite layer is comprised between 100nm to 2µm.

In this invention the term "perovskite" refers to a material which may be represented by the formula 'A"B"X'3, wherein 'A' is at least one cation, 'B' is at least one cation, and 'X' is at least one anion. The cation 'A' can be organic, inorganic, or an organic-inorganic cation. When the cation 'A' is organic, the organic cation can have the formula (R1R2R3R4N)n+ or (R5R6N=CH-NR7R8)n+, where R is hydrogen, unsubstituted or substituted alkyl, or unsubstituted or substituted aryl, and n is equal or superior to one (e.g. 'CH3NH3'+ refers as MA, 'HC(NH2)2'+ refers as FA, 'C(NH2)3'+ refers as GA). When the cation 'A' is inorganic, the cation can be selected from the group consisting of Ag+, Li+, Na+, K+, Rb+, Cs+, Be2+, Mg2+, Ca2+, Pb2+, Sr2+, Ba2+, Fe2+, Sc3+, Y3+, and La3+. The cation can be used as a single or multiple ion (e.g. (Mg,Fe)SiO3), YBaCuO3).
When the cation 'A' is organic-inorganic, the cation can be used as a single or multiple ion such as 'A'=(M1n(R21-xR3x) (100-n)), where R is preferably an organic cation as described above and M is preferably an inorganic cation comprised as described above (e.g. FA1-xGax'B"X'3, Csx(MAnFA1-n) (100-x) 'B"X'3).
The cation 'B' can be a metal cation selected from the group consisting of Pb2+, Sn2+, Ge2+, Bi2+, Cu2+, Au2+, Ag2+, Sb2+, Nb2+, Ti2+, Mg2+, Si2+, Ca2+, Sr2+, Cd2+, Ni2+, Mn2+, Fe2+, Zr4+, Co2+, Pd2+, Yb2+, Eu2+, Ce4+, and Tb4+. The anion 'X' can be selected from the group consisting of halide anions comprising Cl-, Br-, I-, F-, or chalcogenide anions comprising 02-, S2-, Se2-, Te2-, or polyanions comprising BF4-, PF6-, SCN-. The anion can be used as a single or multiple ions such as X'=(R1-xRx), where R is an anion as listed above. The invention also includes other type of perovskites that can be elaborated: Cuprate perovskite (La2-xBaxCuO4, YBa2Cu3O7, Ba2MCu3O7, where M is a rare earth ion such as Pr, Y, Nd, Sm, Gd, Dy, Ho). Metal perovskite can be produced based on a RT3M structure, where R is a rare-earth ion, T is a transition metal ion (Pd, Rh, Ru) and M is a light metalloid (e.g. B, C).
The definition above on the range of materials thus includes, but is not limited to, the following compounds: CH3NH3PbX3, Csx(CH3(NH2)2)1-xPbX3, Csx((CH3NH3)y(CH3(NH2)2)1-y)(1-x)PbX3, AxCsy((CH3NH3)z(CH3(NH2)2)1-z)1-yPbX3 where A is an alkali metal (Li, Na, K, Rb), BaTiO3, PbTiO3, CaTiO3, SrTiO3, PbZr03, SrTi03, KTaO3, KNbO3, NaNbO3, Pb(Mg1/3Nb2/3)O3, Pb(Zn1/3Nb2/3)O3, Pb(Mn1/3Sb2/3)03, Pb(Co1/3Nb2/3)O3, Pb(Mn1/3Nb2/3)O3, Pb(Ni1/3Nb2/3)O3, Pb(Sb1/2Sn1/2)O3, Pb(Co1/2W1/2)O3, Pb(Mg1/2W1/2)O3, LiNbO3, LiTa03, BiTiO3, NaTiO3, NaNbO3, KNbO3, La1-xSrxMnO3, La2NiO4, La2Co04, GdBaCo2O5, PrBaCo2O5, NdBa1-xSrxCoO2O5, Ba1-xSrxCo1-yFeyO3, BiCri-xGaxO3, NaNbO3, KNbO3, LaFe03, LaCoxFe1-xO3, La1-xSrxCoO3, LaSrNiO4, LaxSrx-1FeyBiy-1O3, La2NiO4, La2-xSrxCu04, LaSrNi1-xAlxO4, LaMnO3, LaFe03, LaCoO3, LaTi1-xCuxO3, LiTaO3, NaTaO3, KTaO3, CaTa2O6, SrTa2O6, BaTa2O6, (La1-xSrxCoO3, Pr1-xSrxCoO3, Sm1-xSrxCoO3, Gd1-xSrxCoO3, Tb1-xSrxCoO3, LaCoO3, La1-xSrxMnO3, LaCo1-xNixO3)

According to a further aspect of the present invention, the capping layer of the perovskite top cell is deposited at a temperature lower than 160°C, preferentially below 110°C, to avoid damages to the perovskite material.

According to another aspect of the present invention, the capping layer is configured to prevent recombination of free carriers, and is for example made of polymethylmetacrylat "PMMA", Al₂O₃, SiO₂ or Phenyl-C61-butyric acid methyl ester "PCBM". The capping layer may be used as a passivation layer for the perovskite layer.

According to a further aspect of the present invention, the front contact of the silicon bottom cell is achieved by one of the following solutions:
- a heterojunction of amorphous silicon,
- diffusion doped layers,
- passivating contacts notably polysilicon.

According to another aspect of the present invention, the silicon layer of the silicon bottom cell is made of N-type doped silicon, the front contact of the silicon bottom cell is made of P-type doped silicon and the first carrier transport layer is made of tin oxide "SnO₂".

According to a further aspect of the present invention, the second carrier transport layer comprises a layer of silver doped nickel oxide "Ag:NiO".

According to another aspect of the present invention, the silicon layer of the silicon bottom cell is made of P-type doped silicon, the front contact of the silicon bottom cell is made of N-type doped silicon and the first carrier transport layer is made of nickel oxide "NiOₓ".

According to a further aspect of the present invention, the second carrier transport layer comprises a layer of tin oxide "SnO₂".

According to another aspect of the present invention, the second carrier transport layer comprises a high electrical conductivity, for example by a free carrier concentration of at least 1E²⁰ at a carrier mobility of 10 cm²/Vs, and the pitch is lower than 5mm, for example lower than 3mm.

According to a further aspect of the present invention, the insulator layer is made of Hafnium dioxide "HfO₂" or aluminum oxide Al₂O₃.

The present invention also refers to a method for manufacturing a two terminal tandem cell comprising a silicon bottom cell and a perovskite top cell wherein the method comprises the following steps:
- providing a silicon bottom cell comprising a rear contact configured to be linked to a first terminal and a front contact, the silicon bottom cell corresponding to a first intermediate structure,
- depositing a first carrier transport layer over the front contact of the first intermediate structure to produce a second intermediate structure,
- etching selectively the first carrier transport layer and the front contact of the second intermediate structure to produce a third intermediate structure,
- depositing an insulator layer and a second carrier transport layer configured to be linked to a second terminal over the third intermediate structure to produce a fourth intermediate structure,
- etching the fourth intermediate structure to remove the layers covering the first carrier transport layer to produce a fifth intermediate structure,
- depositing a perovskite layer over the fifth intermediate structure to produce a sixth intermediate structure,
- depositing a capping layer over the sixth intermediate structure at a temperature lower than 110°C.
The silicon bottom cell may be a manufactured silicon cell of the market.

According to a further aspect of the present invention, the deposition steps are made by sputter deposition or atomic layer deposition "ALD" or plasma-enhanced chemical vapor deposition "PECVD" or similar physical and chemical vapor phase deposition techniques and the etching steps are made by chemical or physical etching. The perovskite deposition may be made by any combination of wet and vacuum based deposition processes.

### Brief description of the drawings

[Fig.1] is a diagram of the different layers of a photovoltaic cell according to a general embodiment of the invention;
[Fig.2] is a diagram of the different layers of a photovoltaic cell according to a particular embodiment of the invention;
[Fig.3A] is a perspective view of a photovoltaic tandem cell according to the present invention;
[Fig.3B] is a sectional view of one photovoltaic tandem cell element of fig.3A according to a A-A cut line;
[Fig.3C] is a sectional view of one photovoltaic tandem cell element of fig.3A according to a B-B cut line;
[Fig.3D] is a sectional view of one photovoltaic tandem cell element of fig.3A according to a C-C cut line;
[Fig.3E] is a sectional view of one photovoltaic tandem cell element of fig.3A according to a D-D cut line;
[Fig.3F] is a sectional view of one photovoltaic tandem cell element of fig.3A according to a E-E cut line;
[Fig.4A] is a diagram of the efficiency and the open circuit voltage as a function of the free carrier concentration in the second carrier transport layer;
[Fig.4B] is a diagram of the fill factor and the short circuit current density as a function of the free carrier concentration in the second carrier transport layer;
[Fig.4C] is a diagram of the absorber photocurrent density and the residual photocurrent density in the second carrier transport layer as a function of the free carrier concentration in the second carrier transport layer;
[Fig.5] is a flowchart of different manufacturing steps of a tandem photovoltaic cell according to the invention;
[Fig.6] is a diagram of a first intermediate structure during the manufacturing process of a tandem photovoltaic cell according to the invention;
[Fig.7] is a diagram of a second intermediate structure during the manufacturing process of a tandem photovoltaic cell according to the invention;
[Fig.8] is a diagram of a third intermediate structure during the manufacturing process of a tandem photovoltaic cell according to the invention;
[Fig.9] is a diagram of a fourth intermediate structure during the manufacturing process of a tandem photovoltaic cell according to the invention;
[Fig.10] is a diagram of a fifth intermediate structure during the manufacturing process of a tandem photovoltaic cell according to the invention;
[Fig.11] is a diagram of a sixth intermediate structure during the manufacturing process of a tandem photovoltaic cell according to the invention.

### Detailed description of the invention

The following achievements are examples. Although, the specification refers to one or several embodiments, it does not imply that each reference refers to the same embodiment or that the features apply only to a single embodiment. Simple features of different embodiments can also be combined to provide other embodiments.

The present invention refers to a two terminal "2T" tandem photovoltaic cell comprising a silicon based bottom cell and a perovskite based top cell wherein the perovskite top cell comprises alternated back contacts and a capping layer configured as a passivation (and/or encapsulation) layer for the perovskite layer.

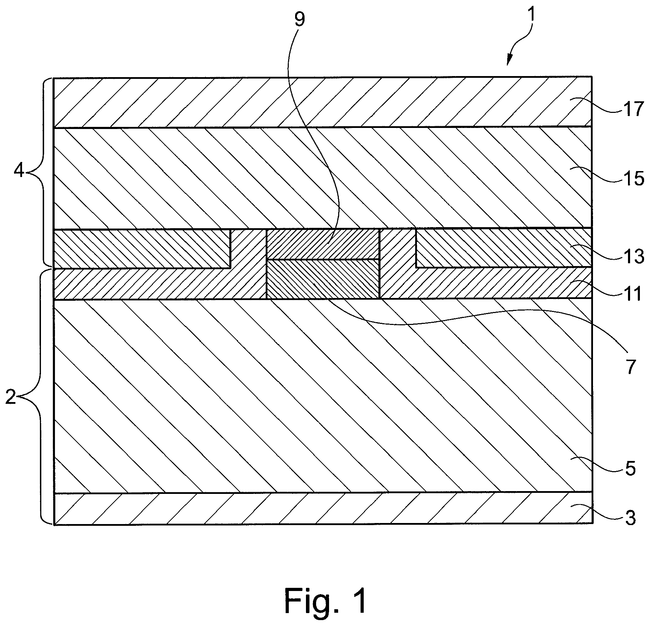

Fig.1 represents a diagram of the stack of the different layers of such tandem photovoltaic cell 1.

The tandem photovoltaic cell 1 comprises a rear contact layer 3, a silicon layer 5 and a localized front contact layer 7. By localized front contact layer 7, we herein mean that the front contact layer 7 does not cover all the surface of the silicon layer 5 but is localized for example in the shape of stripes extending across the silicon layer 5. These layers (3, 5 and 7) correspond to the silicon bottom cell 2. A first carrier transport layer 9 is arranged over the front contact layer 7 to produce a recombination layer or a tunnel junction interface between the silicon bottom cell 2 and the perovskite top cell 4. An insulator layer 11 is arranged over the portions of silicon layer 5 without front contact 7. A second carrier transport layer 13 is arranged over the insulator layer 11 and is alternated with the portions of the first carrier transport layer 9. Two adjacent portions of first 9 and second 13 carrier transport layers are separated by an insulator layer 11. The tandem photovoltaic cell 1 comprises for example a first series of stripes corresponding to the first carrier transport layer 9 and a second series of stripes corresponding to the second carrier transport layer 13, the first and the second series being alternated and separated by stripes of insulator layer 11. A perovskite layer 15 is arranged over the first 9 and second 13 carrier transport layers and a capping layer 17 is arranged over the perovskite layer 15. The first 9 and second 13 carrier transport layers, the perovskite layer 15 and the capping layer 17 correspond to the perovskite top cell 4.

A first terminal is linked to the rear contact layer 3 and a second terminal is linked to the portions of the second carrier transport layer 15.

The front contact 7 may be made by diffusion doped layers or by heterojunction such as amorphous silicon "SiA" or by passivating contacts such as polysilicon.

As indicated previously, the front contact 7 and the first carrier transport layer 9 may form a recombination layer wherein for example the electrons from the perovskite layer 15 are recombined with holes of the silicon layer 5 to produce pairs of electron-hole. Alternatively, the front contact 7 and the first carrier transport layer 9 may form a tunnel junction enabling for example electrons from the perovskite layer 15 to be transmitted toward the silicon layer 5 to be collected at the first terminal.

Depending on the doping of the different layers, the electrons may come from the silicon bottom cell 2 and be recombined in the recombination layer (7 and 9) or be transmitted toward the perovskite layer 15 to be collected at the second terminal.

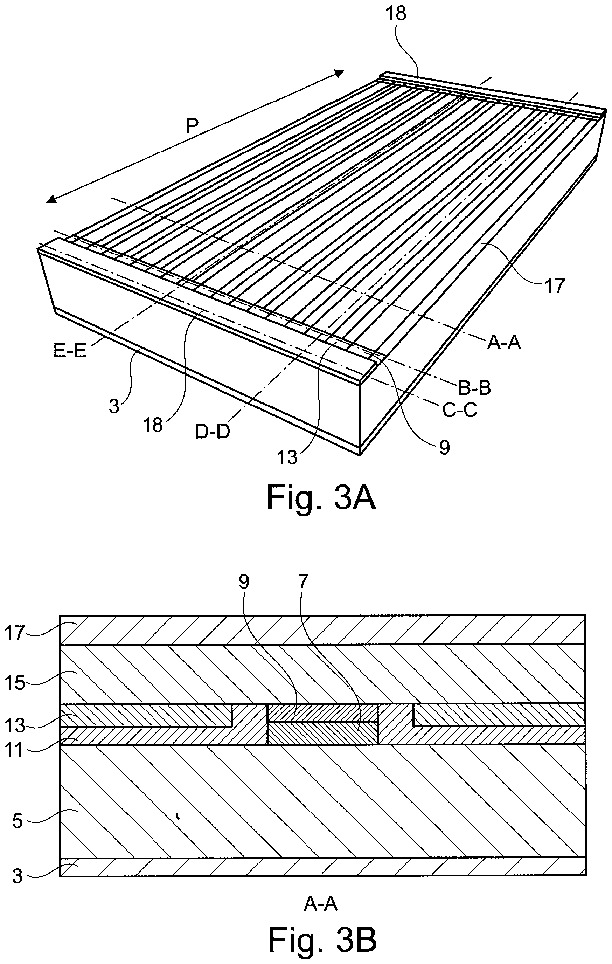

The first 9 and the second 15 carrier transport layers are configured to have opposite doping type. One has a N-type doping while the other has a P-type doping. Different material may be used for the first 9 and second 13 carrier transport layers such as TiO2, NiO, ZnO, MnO, CuSCN, SnO₂, CuO, CrO, SrO or VO...The first 9 and the second 13 carrier transport layers together with the insulator layer 11 form a horizontal P-I-N configuration of the perovskite top cell 4 as represented in Fig.3B.

The silicon based bottom cell 2 comprising the rear contact 3, the silicon layer 5 and the front contact 7 may be a silicon photovoltaic cell of the market (without anti-reflection layer) and the other layers may then be deposited (and possibly etched) over the provided silicon cell. Furthermore, concerning the capping layer 17, its deposition should be achieved at a temperature lower than 160°C, preferentially below 110°C, to avoid damaging the perovskite layer 15. Such low temperature may be achieved due to the fact that no collection of free carriers is achieved at the capping layer 17. The capping layer 17 may be configured to avoid recombination of electron-hole pairs in the capping layer 17.

The capping layer 17 may also be made from typical charge transport materials, such as Phenyl-C61-Butyric acid Methyl ester "PCBM".

Such structure enables therefore the deposition of the carrier transport layers 9 and 13 requiring a high temperature process, for example 200°C or more to be achieved before the deposition of the perovskite layer 15.

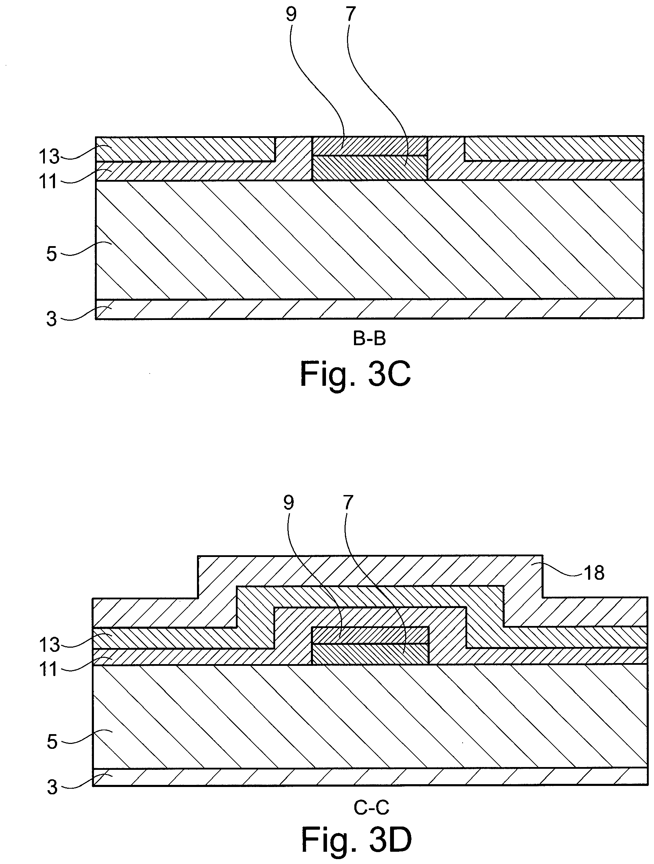

It has to be noted that Fig.1 represents a basic pattern which may be replicated laterally to produce an alternation of portions of first carrier transport layer 9 and portions of second carrier transport layer 13 which are interdigitated as represented in fig.3A. Thus, lateral dimensions may be extended to large scale manufacturing. Fig.3B represents a sectional view according to the cut line A-A which extends laterally across a central portion of the tandem photovoltaic cell 1 as represented in Fig.3A. However, it has to be noted that Fig.3B represents only a portion of the section A-A comprising two stripes of second carrier transport layer 13 and one stripe of first carrier transport layer 9 but as indicated the pattern of fig.3B is replicated multiple times across the A-A section. It has also to be noted that fig.3B corresponds to fig.1. Fig.3C represents a sectional view according to the cut line B-B which also extends laterally but across a portion of the tandem photovoltaic cell 1 without the perovskite layer 15 and without the capping layer 17.

Fig.3D represents a sectional view according to the cut line C-C which extends laterally across a lateral portion of the tandem photovoltaic cell 1 comprising the metallic contacts 18 as represented in Fig.3A. In this C-C section, the insulator layer 11 covers the first carrier transport layer 9 and the second carrier transport layer 13 is disposed all over the insulator layer 11. The metallic contact 18 also called finger is then disposed over the second carrier transport layer 13.

Actually, the portions of first carrier transport layer 9 and the portions of second carrier transport layer 13 are not exactly interdigitated. Indeed, the portions of the second carrier transport layer 13 (in the shape of parallel stripes as represented in fig.3A for example) are linked to metallic contacts 18 (also called fingers) at both of their extremities whereas there is no connection between the portions (also parallel stripes for example) of the first carrier transport layer 9 at their extremities.

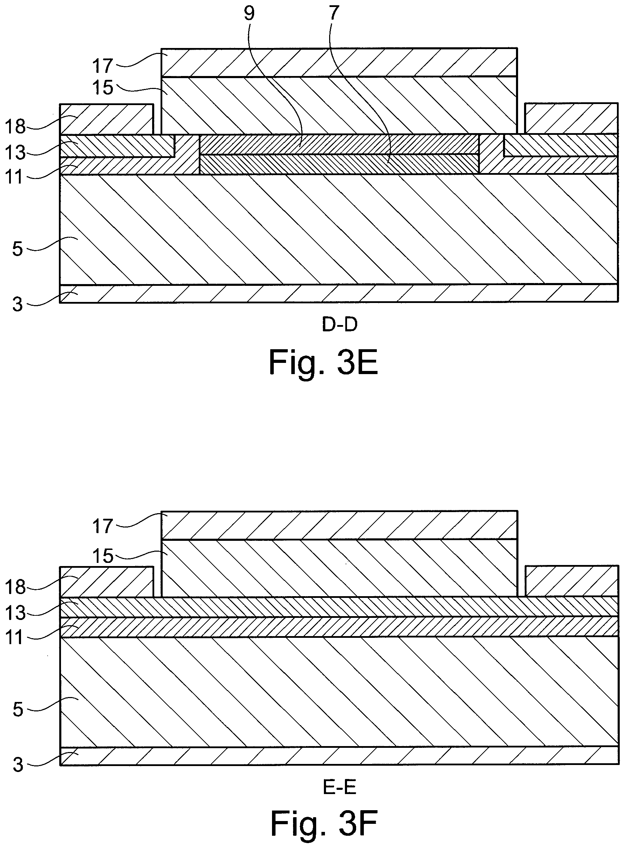

Fig.3E represents a sectional view according to the cutline D-D which extends across a longitudinal portion of the tandem photovoltaic cell 1 along a stripe of first carrier transport layer 9. The stripe of the first carrier transport layer 9 does not extend over the whole length of the tandem photovoltaic cell 1 but only remains in the central part without metallic contact. An insulator layer 11 is disposed at both ends of the stripe of the first carrier transport layer 9. The insulator layer 11 is then covered by a second carrier transport layer 13 and a metallic contact 18 at the longitudinal ends of the tandem photovoltaic cell 1 whereas in the central part, the first carrier transport layer is covered by the perovskite layer 15 and the capping layer 17. A gap is arranged between the perovskite layer 15 and capping layer 17 of the central part a Thus, there is no contact between the stripes of first carrier transport layer 9 and the metallic contacts 18. There is also no contact between the different stripes of first carrier transport layer 9.

Fig.3F represents a sectional view according to the cutline E-E which extends across a longitudinal portion of the tandem photovoltaic cell 1 along a stripe of the second carrier transport layer 13. The stripe of the second carrier transport layer 9 extends over the whole length of the tandem photovoltaic cell 1. The central part of the stripe is covered by a perovskite layer 15 and a capping layer 17 whereas the end parts are covered by the metallic contacts 18. A gap is arranged between the perovskite layer 15 and capping layer 17 of the central part and the metallic contacts 18 of the end parts o the tandem photovoltaic cell 1. The different stripes of second transport carrier layer 13 are therefore connected to each other.

Besides, concerning the second carrier transport layer 13, its free carrier concentration, its thickness and its pitch P are configured to ensure the lateral transport of the free carrier toward the second terminal (which is linked to the metallic contact s 18). The pitch P corresponds to the distance between the ends of a portion of the second carrier transport layer 13 as represented in Fig.3A or more precisely to the distance between the two metallic contacts 18 arranged at both ends of the second carrier transport layer 13 The metallic contacts 18 may be made of Au, Ag, Al, Cu or other metal or alloys..

Thus, the concentration of free carrier in the second carrier transport layer 13 may be increased in order to allow the use of a larger pitch P and a higher thickness of the second carrier transport layer 13. Furthermore, the second carrier layer 13 may comprise one or several sub-layers made of metal or transparent conducting oxide to enhance the lateral conductivity. These sub-layers may sandwich the main layer of the second carrier transport layer 13.

The thickness of the first 9 and second 13 carrier layers as well as the insulator layer 11 are comprised between 2nm and 1µm. The thickness of the perovskite layer 15 is comprised between 100nm and 2µm.

The capping layer 17 may partly embed into the grain boundaries of the perovskite layer 15. The capping layer 17 may be made of any suitable material which may be deposited at a temperature below 110°C and which is stable with respect to the ultra-violet rays. Examples of such materials are, PMMA, Al₂O₃, ...

The thickness of the capping layer 17 may be comprised between 10nm and 200nm.

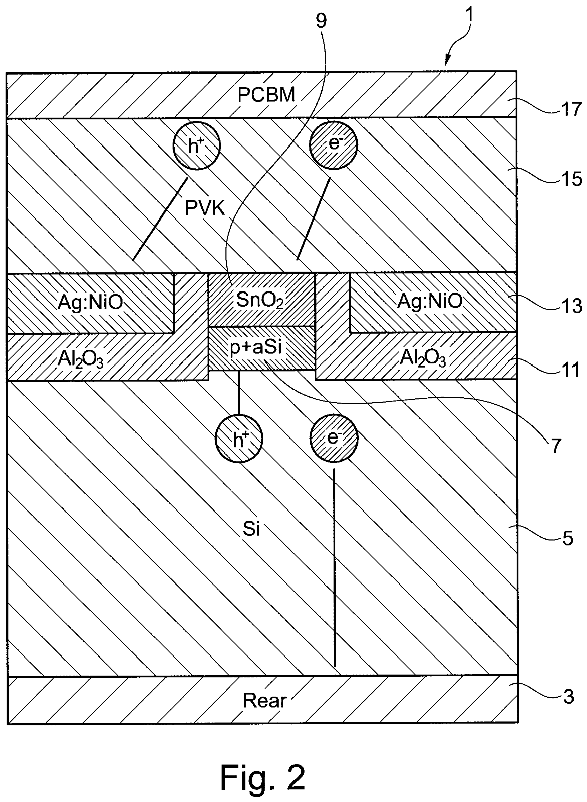

Fig.2 represents an embodiment of the present invention. In this embodiment, the front contact 7 of the silicon bottom cell 2 is made of a P-type doped amorphous silicon "p+aSi" and the first carrier transport layer 9 is made of tin oxide "SnO₂". The first carrier transport layer 9 is a N-type doped layer. As indicated previously, the combination of the front contact 7 made of p-type doped amorphous silicon and the tin oxide layer 9 produces a tunnel junction between the silicon bottom cell 2 and the perovskite top cell 4.

The insulator 11 may be made of an insulating oxide, such as hafnium oxide HfO₂ or aluminum oxide Al₂O₃.

The second carrier transport layer comprises silver doped nickel oxide "AgNiO" and is a P-type doped layer. As indicated previously, the layer of AgNiO may be sandwiched with sub-layers of a metal such as Ni or a transparent conductive oxide "TCO" such as indium tin oxide "ITO" to enhance its lateral conductivity. However, the thickness of a TCO sub-layer needs to remain weak, for example smaller than 100nm in order to limit parasitic absorption in the near infra-red spectrum. The pitch P of the second carrier transport layer 13 is chosen smaller than 5mm, for example smaller than 3mm.

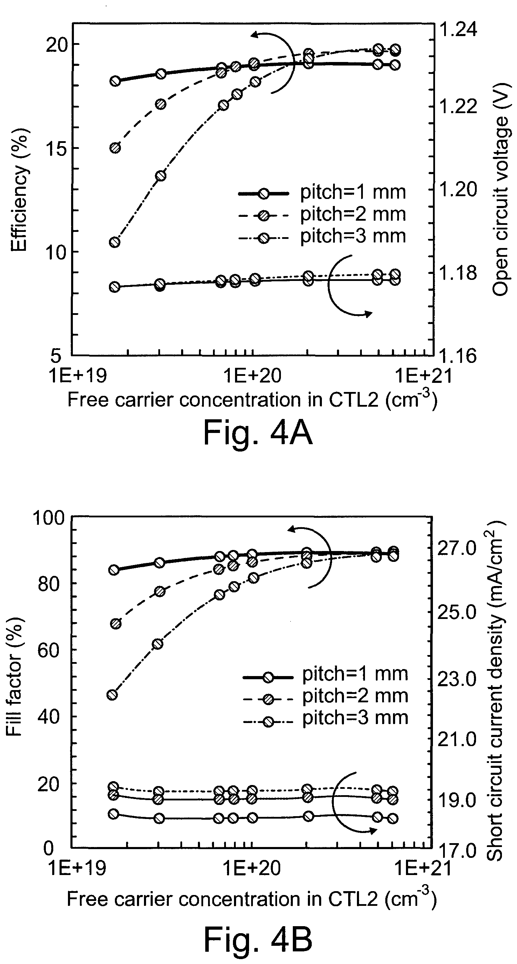

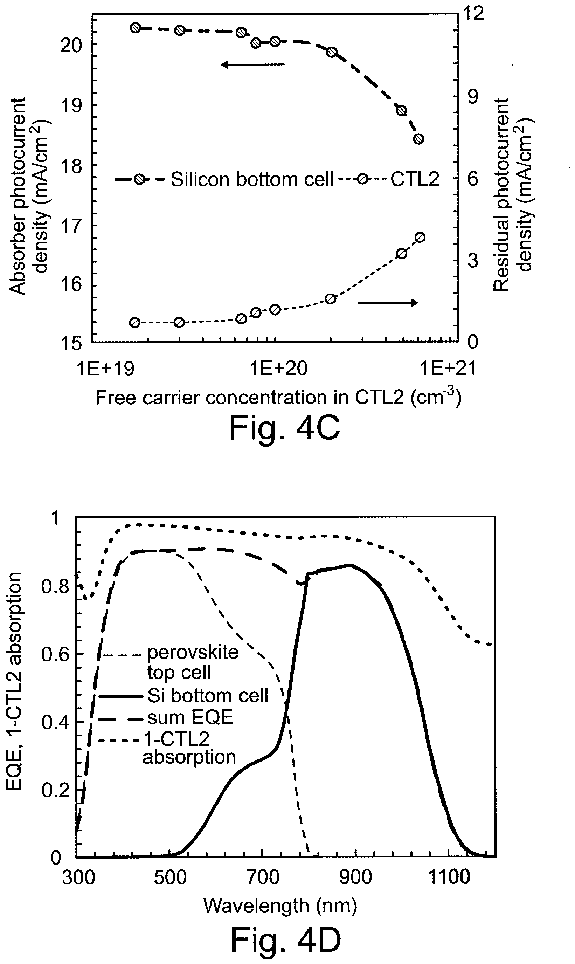

Fig.4A to 4C show different simulations achieved on different configurations of the second carrier transport layer 13 and may be used to determine the different parameters and notably the free carrier concentration according to the desired pitch P. In this simulation a 100nm thick ITO layer with a carrier mobility of 10cm²/Vs is studied as the second carrier transport layer 13 with various free carrier concentration from 1,7E¹⁹ and 6,1E²⁰ cm⁻³. Indeed, Fig.4A represents the simulated efficiency and open circuit voltage of the perovskite top cell in a tandem architecture as a function of the free carrier concentration for different values of pitch P, respectively 1mm, 2mm and 3mm. Fig.4B shows the simulated fill factor and short circuit current density of the perovskite top cell 4 in a tandem architecture as a function of the free carrier concentration for different values of pitch P, respectively 1mm, 2mm and 3mm. Fig.4C shows the simulated absorber photocurrent density in the silicon bottom cell 2 and the residual photocurrent density in the second carrier transport layer 13 as a function of the free carrier concentration.

One can observe that a concentration of 1E²⁰ cm⁻³ is necessary for pitches P higher than 1mm to obtain an efficiency higher than 18% or a fill factor higher than 80%. The low fill factor arises from the increase of non-radiative recombination in the perovskite layer 15 and the increase of serial resistance in the second carrier transport layer 13.

It also appears that no significant variation is found on the open circuit voltage and the short circuit current density. Significant loss of photocurrent density in the silicon bottom cell is observed when the free carrier concentration in the second carrier transport layer is larger than 1E²⁰ cm⁻³.

Fig.4D represents the simulated external quantum efficiency "EQE" of the perovskite top cell 4 and the silicon bottom cell 2 and the sum of both of them as well as the residual absorption spectrum of the second carrier transport layer 13. Fig.4D shows that the second carrier transport layer 13 of high free carrier concentration mostly introduces photocurrent losses in the infra-red region of the spectrum which results in less photocurrent generated in the silicon bottom cell and therefore to a lower efficiency. Thus, to obtain high efficiency of a perovskite/silicon tandem photovoltaic cell, the free carrier concentration in the second carrier transport layer 13 has to be adjusted to balance the lateral conductivity and the infra-red transparency and therefore to obtain a tandem photovoltaic cell with an improved yield.

The perovskite layer 15 may be an intrinsic layer or a N-doped perovskite layer. The capping layer 17 may be made of Phenyl-C61-Butyric acid Methyl ester "PCBM".

The present invention is not limited to the embodiment represented in Fig.2 which is only a particular example. Two terminal tandem cell comprising other types of material notably for the front contact layer, the first and second carrier transport layers, the insulator layer or the capping layer are also covered by the present invention.

The present invention also refers to an exemplary method for manufacturing a two-terminal "2T" tandem photovoltaic cell comprising a silicon based bottom cell 2 and a perovskite based top cell 4. Other manufacturing methods may be envisaged.

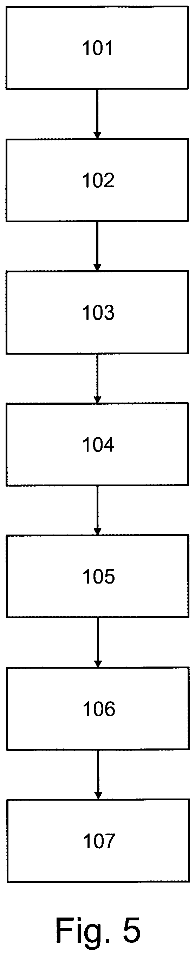

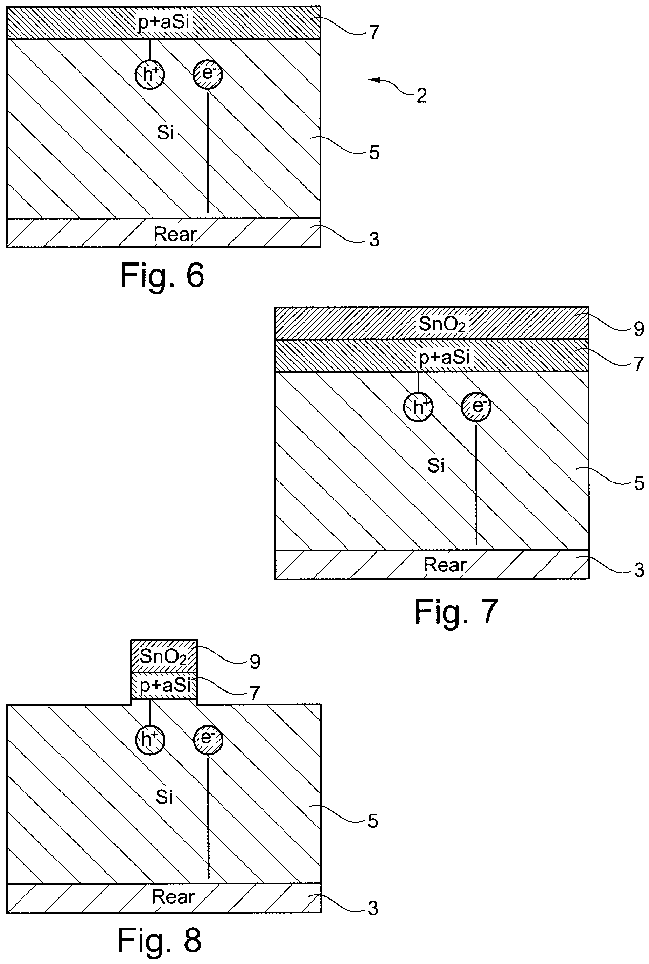

Fig.5 represents the different steps of the manufacturing method.
The first step 101 refers to providing a silicon bottom cell 2 corresponding to a first intermediate structure. Such silicon bottom cell 2 may be provided by a manufacturer of the market. Preferably, the silicon bottom cell 2 is provided without anti-reflection layer. As represented in fig.6, the silicon bottom cell 2 comprises a rear contact 3 configured to be linked to a first terminal of the tandem photovoltaic cell, a silicon layer 5 arranged over the rear contact 3 and a front contact 7 arranged over the silicon layer 5.

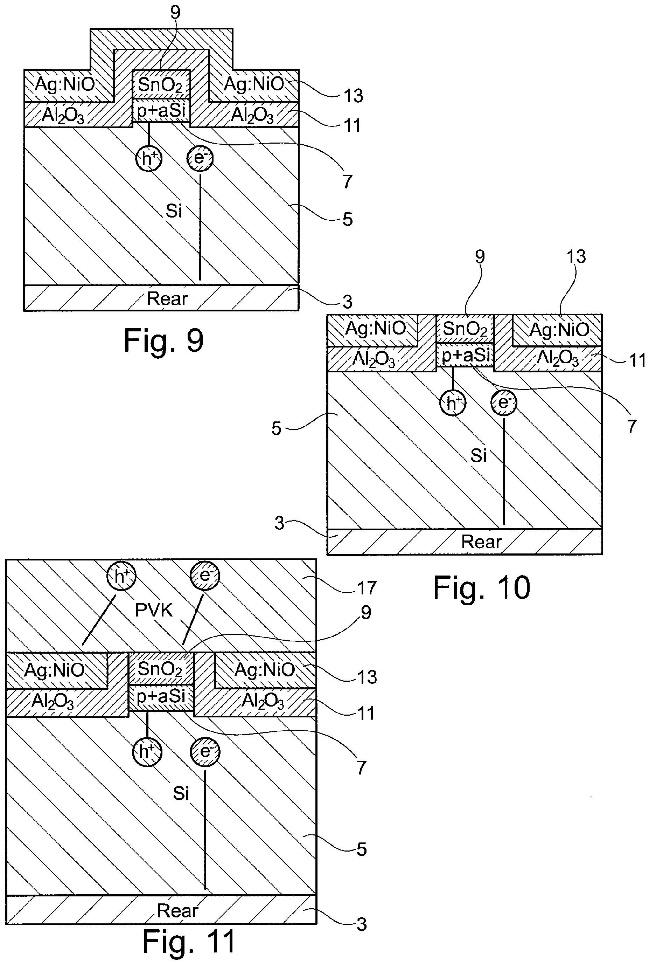

The second step 102 refers to depositing a first carrier transport layer 9 over the front contact layer 7 as represented in Fig.7 which represents a second intermediate structure. This deposition may be sputter deposition or atomic layer deposition "ALD" or plasma-enhanced chemical vapor deposition "PECVD" or similar physical and chemical vapor phase deposition techniques.
The third step 103 refers to etching selectively the first carrier transport layer 9 and the front contact layer 7 to produce a third intermediate structure represented in Fig.8. In Fig.8, only one stripe of contact layer 7 and first carrier transport layer 9 is represented but in practice several parallel stripes may be achieved. The etching may be a chemical or a physical etching according to a process known from the state of the art.
The fourth step 104 refers to depositing an insulator layer 11 and a second carrier transport layer 13 over the third intermediate structure to produce a fourth intermediate structure as . represented in Fig.9.
The second carrier transport layer 13 is configured to be linked to a second terminal of the tandem photovoltaic cell 1, for example via metallic contacts 18 arranged at the ends of the stripes of the second carrier transport layer 13. These depositions may be sputter deposition or atomic layer deposition "ALD" or plasma-enhanced chemical vapor deposition "PECVD" or similar physical and chemical vapor phase deposition techniques.
The fifth step 105 refers to etching the fourth intermediate structure to remove the layers covering the first carrier transport layer 9 to produce a fifth intermediate structure as represented in Fig.10. Such etching enables obtaining a smooth structure with an alternation of stripes of the first 9 and of the second 13 carrier transport layers, two adjacent stripes being separated by an insulator layer 11 to provide a plurality of P-I-N junctions along the lateral axis of the tandem photovoltaic cell. The etching may be a chemical or a physical etching according to a process known from the state of the art.
The sixth step 106 refers to depositing a perovskite layer 15 over the fifth intermediate structure to produce a sixth intermediate structure as represented in Fig.11. This deposition may be performed via single-step or multi-step state-of-the-art wet solution processing, such as spin-casting, slot-die coating etc, vacuum based processes such as thermal evaporation or hybrid deposition processes combining wet- and vacuum-based procedures.
The seventh step 107 refers to depositing a capping layer 17 over the sixth intermediate structure at a temperature lower than 160°C, in particular lower than 110°C to obtain the stack of layers of the embodiment of the invention presented in Fig.2..

Thus, the present invention discloses a structure of a two-terminal "2T" perovskite/silicon tandem photovoltaic cell enabling reaching a high efficiency due to the combination of the silicon bottom cell 2 and the perovskite top cell 4 while allowing a protection of the perovskite due to the use of a passivation layer or capping layer 17 which is deposited at a temperature below 110°C. The perovskite layer 15 is therefore not damaged during the manufacturing process but is protected from O₂ or H₂O from the environment. Furthermore, the two terminal "2T" structure allows limiting losses. The present invention also refers to the configuration of the second carrier transport layer 13 to obtain a balance between the lateral conductivity and the infra-red transparency leading therefore to an adjustable structure providing enhanced performances.

## Claims

1. Two terminal tandem cell (1) comprising:
- a silicon bottom cell (2) comprising a silicon layer (5), a rear contact (3) configured to be linked to a first terminal and a front contact (7),
- a perovskite top cell (4) comprising a layer of perovskite (15) and a capping layer (17),
wherein the perovskite top cell comprises alternated back contacts made by a first carrier transport layer (9) arranged on the front contact (7) of the silicon bottom cell (2) to produce a recombination layer or a tunnel junction interface and a second carrier transport layer (13) configured to be linked to a second terminal and wherein an insulator layer (11) is arranged on one side between the silicon bottom cell (2) and the second carrier transport layer (13) and on the other side between the first carrier transport layer (9) and the second transport layer (13).

2. Two terminal tandem cell (1) in accordance with claim 1 wherein the electrical conductivity, the thickness and the pitch (P) of the second carrier transport layer (13) are configured to ensure lateral carrier transport toward the second terminal.

3. Two terminal tandem cell (1) in accordance with one of the previous claims wherein the second carrier transport layer (13) comprises at least one sub-layer made of metal or transparent conducting oxide to enhance lateral carrier transport toward the second terminal.

4. Two terminal tandem cell (1) in accordance with one of the previous claims wherein the first carrier transport layer (9) and the second carrier transport layer (13) have opposite doping type.

5. Two terminal tandem cell (1) in accordance with one of the previous claims wherein the thickness of the first carrier transport layer (9), the second carrier transport layer (13) and the insulator layer (11) is comprised between 2nm and 1µm, preferably between 10nm and 100nm.

6. Two terminal tandem cell (1) in accordance with one of the previous claims wherein the thickness of the perovskite layer (15) is comprised between 100nm to 2µm.

7. Two terminal tandem cell (1) in accordance with one of the previous claims wherein the capping layer (17) of the perovskite top cell (4) is deposited at a temperature lower than 160°C.

8. Two terminal tandem cell (1) in accordance with one of the previous claims wherein the capping layer (17) is configured to prevent recombination of free carriers, and is for example made of polymethylmetacrylat "PMMA", Al₂O₃ or SiO₂.

9. Two terminal tandem cell (1) in accordance with one of the previous claims wherein the front contact (7) of the silicon bottom cell (2) is achieved by one of the following solutions:
- a heterojunction of amorphous silicon,
- diffusion doped layers,
- passivating contacts notably polysilicon.

10. Two terminal tandem cell (1) in accordance with one of the previous claims wherein the silicon layer (5) of the silicon bottom cell (2) is made of N-type doped silicon, the front contact (7) of the silicon bottom cell (2) is made of P-type doped silicon and the first carrier transport layer (9) is made of tin oxide "SnO₂".

11. Two terminal tandem cell (1) in accordance with the previous claim wherein the second carrier transport layer (13) comprises a layer of silver doped nickel oxide "Ag:NiO".

12. Two terminal tandem cell (1) in accordance with one of the claims 1 to 9 wherein the silicon layer (5) of the silicon bottom cell (2) is made of P-type doped silicon, the front contact (7) of the silicon bottom cell (2) is made of N-type doped silicon and the first carrier transport layer (9) is made of nickel oxide "NiOₓ".

13. Two terminal tandem cell (1) in accordance with the previous claim wherein the second carrier transport layer (13) comprises a layer of tin oxide "SnO₂".

14. Two terminal tandem cell (1) in accordance with one of the previous claims wherein the second carrier transport layer (13) comprises a free carrier concentration of at least 1E²⁰ and a pitch (P) which is lower than 5mm, for example lower than 3mm.

15. Two terminal tandem cell (1) in accordance with one of the previous claims wherein the insulator layer (11) is made of Hafnium dioxide "HfO₂", or aluminum oxide "Al₂O₃".

16. Method for manufacturing a two terminal tandem cell (1) comprising a silicon bottom cell (2) and a perovskite top cell (4) wherein the method comprises the following steps:
- providing (101) a silicon bottom cell (2) comprising a rear contact (3) configured to be linked to a first terminal and a front contact (7), the silicon bottom cell corresponding to a first intermediate structure,
- depositing (102) a first carrier transport layer (9) over the front contact (7) of the first intermediate structure to produce a second intermediate structure,
- etching (103) selectively the first carrier transport layer (9) and the front contact (7) of the second intermediate structure to produce a third intermediate structure,
- depositing (104) an insulator layer (11) and a second carrier transport layer (13) configured to be linked to a second terminal over the third intermediate structure to produce a fourth intermediate structure,
- etching (105) the fourth intermediate structure to remove the layers covering the first carrier transport layer (9) to produce a fifth intermediate structure,
- depositing (106) a perovskite layer (15) over the fifth intermediate structure to produce a sixth intermediate structure,
- depositing (107) a capping layer (17) over the sixth intermediate structure at a temperature lower than 110°C.

17. Manufacturing method in accordance with the previous claim wherein the deposition steps (102, 104 and 107) are made by sputter deposition or an atomic layer deposition "ALD" or plasma-enhanced chemical vapor deposition " PECVD " or physical and chemical vapor phase deposition techniques.
